# EUROPEAN PATENT SPECIFICATION

(11) **EP 1 558 673 B1**
(45) Date of publication and mention of the grant of the patent: **28.11.2007**
(21) Application number: 03779332.0
(22) Date of filing: 24.10.2003
(51) Int. Cl.: C08K 3/08, C08K 3/22, H01L 21/00, H01F 1/08, H01F 1/053

(54) **PLASMA RESISTANT ELASTOMER PARTS**
PLASMABESTÄNDIGE ELASTOMERTEILE
PIECES EN ELASTOMERE RESISTANT AU PLASMA

(30) Priority: 29.10.2002 US 421947 P; 20.10.2003 US 689329
(43) Date of publication of application: 03.08.2005
(73) Proprietor: DUPONT DOW ELASTOMERS L.L.C., Wilmington, DE 19809 (US)
(72) Inventor: IWAMOTO, Kaori 202, Premier, 443, Utsunomiya-Shi, Tochigi 321-0962 (JP); RAI, Bunichi, Meguro-Ku, Tokyo 152-0035 (JP); SOGO, Shinichi 1-7-5 Ushikubo Higashi, Yokohama-Shi, Kanagawa 224-0014 (JP)
(74) Representative: Gritschneder, Martin
(86) International application number: PCT/US2003/034110
(87) International publication number: WO 2004/039876

(56) References cited:
- EP-A- 1 331 652
- EP-A1- 0 651 425
- EP-A1- 1 253 172
- WO-A-00/74541
- WO-A-98/50460
- GB-A- 2 148 049
- US-A1- 2002 084 439

## Description

### FIELD OF THE INVENTION

This invention relates to slit valve doors and pipe flanges comprising elastomer parts which are resistant to attack by certain plasmas due to a magnetic flux density of at least 1 mT, i.e. millitesla (10 gauss) on the surface of the parts.

### BACKGROUND OF THE INVENTION

Elastomer sealing components used in equipment for manufacture of electronic components, for example semi-conductor devices, must meet unusually stringent property requirements. Specifically, the seals are often exposed to reactive plasmas, corrosive cleaning gases and high temperatures that may cause degradation of the elastomer, resulting in loss of physical properties and generation of residue material which may contaminate the semi-conductor devices being manufactured.

Typically, elastomer parts which will be exposed to plasmas in semiconductor manufacturing equipment are fabricated from perfluoroelastomers, fluoroelastomers or silicone elastomers because of their natural resistance (listed in decreasing order) to reactive plasmas. However, even perfluoroelastomers degrade over time when exposed to reactive plasmas.

EP-A1-0 651 425 discloses a process for protecting a polyimide part from degradation due to exposure to a reactive plasma said process comprising imparting a magnetic flux density to a surface of said part by means of an external permanent magnet.

Others have improved the plasma resistance of perfluoroelastomers by judicious selection of compounding additives. For example, Legare (U.S. Patent No. 5,696,189) substituted a metallic filler for carbon black and included titanium dioxide and an acid acceptor in his elastomer seal compositions. Katsuhiko et al. (JP 3303915 82) employed fine particle size aluminum oxide in elastomer seal compositions. Both patents disclose seals having improved resistance to attack by plasmas and reduced residue formation. However, there remains a need in the industry for elastomer parts having still better plasma resistance. Thus, an object of the present invention are slit valve doors and pipe flanges comprising elastomer parts that are more resistant to attack by plasma than are prior art parts, as evidenced by less weight loss and by reduced production of residue due to exposure to plasma.

### SUMMARY OF THE INVENTION

An aspect of the present invention are slit valve doors and pipe flanges comprising an elastomer part having a magnetic flux density of at least 1 millitesla (10 gauss) at its surface. The magnetic flux at the surface of the part arises from an external magnetic source such as one or more permanent magnets placed in close proximity to the surface of the part.

### BRIEF DESCRIPTION OF THE DRAWINGS

Fig. 1 shows an elevated side view of an O-ring seal containing a plurality of internal permanent magnets with poles aligned in the same direction. Fig. 1 does not show the claimed invention.
Figs. 2A and 2B, respectively, show a plan view and a cross-section view taken along line 2B-2B of an elastomer part (i.e. an O-ring seal) having an external magnet mounted in close proximity to the surface of the O-ring. Figs. 2A and 2B do not show the claimed invention
Figs. 3A and 3B, respectively, show a plan view and a cross-section view taken along line 3B-3B of an elastomer part of this invention mounted in a slit valve door, said part having a plurality of external magnets mounted in close proximity to the surface of the part.
Figs. 4A and 4B, respectively, show a plan view and a cross-section view taken along line 4B-4B of an elastomer part of this invention mounted in a pipe flange, said part having a plurality of external magnets mounted in close proximity to the surface of the part.

### DETAILED DESCRIPTION OF THE INVENTION

The elastomer parts of the slit valve doors or pipe flanges of this invention have a magnetic flux density of at least 1 mT (10 gauss), preferably at least 20 mT (200 gauss), at their surface for repelling a portion of the charged particles present in reactive plasmas. Thus the surfaces of the elastomeric parts of this invention which are exposed to plasmas are not subject to the same degree of attack and polymer degradation as are the exposed surfaces of similar parts that do not have a magnetic flux density of at least 1 mT (10 gauss) at their surface. The elastomer parts of this invention produce less contaminating residue and experience reduced weight loss when exposed to reactive plasmas than do similar elastomer parts that are not protected by a magnetic flux at their surface. In fact, weight loss of elastomer parts of this invention is typically reduced by 20% (preferably 50%) relative to the weight loss experienced by similar parts, not protected by a magnetic flux.

Elastomers suitable for use in the compositions of the parts of this invention include, but are not limited to perfluoroelastomers, fluoroelastomers, silicones, nitrile rubbers and ethylene elastomers such as chlorinated polyethylenes, EPDM, ethylene/olefin copolymers, etc. Perfluoroelastomers, fluoroelastomers and silicone rubbers are preferred. Perfluoroelastomers are especially preferred. Typical perfluoroelastomers, fluoroelastomers and suitable curative systems have been well described in the art. See for example, U.S. Patent Nos. 6,281,296 B1; 6,114,452; 5,789,489; 4,214,060; and 3,876,654.

Additives, such as fillers, stabilizers, plasticizers, lubricants, and processing aids typically utilized in elastomer compounding can be incorporated into the elastomer parts of the present invention, provided that they have adequate stability for the intended service conditions.

Fillers such as carbon black, fluoropolymers, polyimides, and inorganic fillers (e.g. silicon dioxide, aluminum oxide, aluminum silicate, and barium sulfate) are used in elastomer compositions employed in this invention as a means to balance modulus, tensile strength, elongation, hardness, abrasion resistance, conductivity, and processability of the compositions. Fluoropolymer fillers (fibrillated or non-fibrillated) can be any finely divided, easily dispersed plastic fluoropolymer that is preferably solid at the highest temperature utilized in fabrication and curing of the elastomer composition. By solid, it is meant that the fluoroplastic, if partially crystalline, will have a crystalline melting temperature above the processing temperature(s) of the elastomer(s). Such finely divided, easily dispersed fluoroplastics are commonly called micropowders or fluoroadditives. When used in the compositions of this invention, 1-70 parts by weight filler per 100 parts by weight rubber (i.e. elastomer) (phr) is generally sufficient.

A whitener, such as titanium dioxide may also be present in the elastomer compositions employed in this invention.

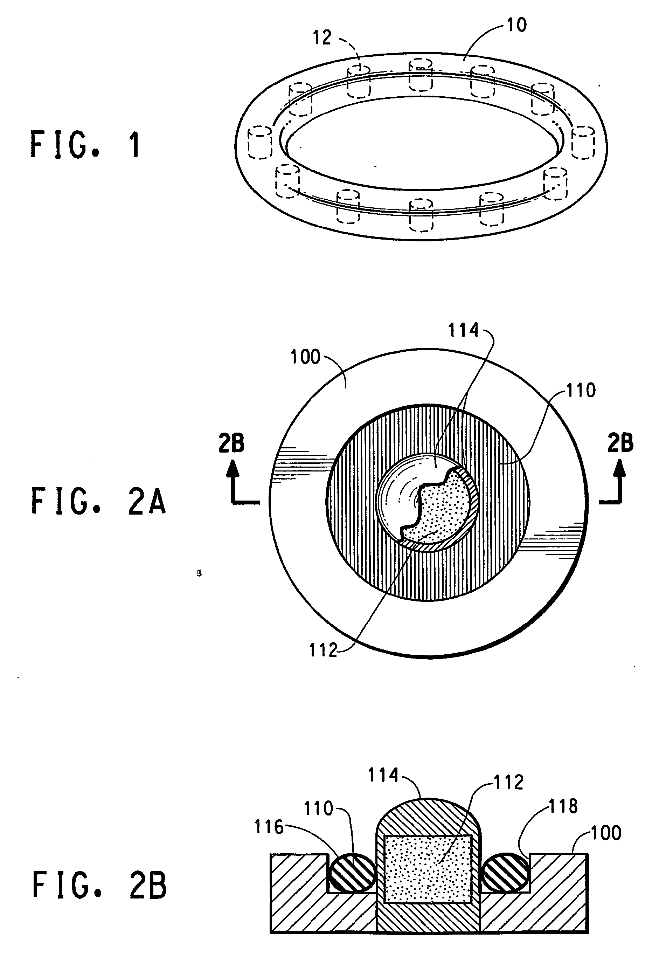

Referring to Fig. 1, an elastomer part 10 used in this invention may contain an internal magnetic material 12 in order to generate the required magnetic flux density at the surface of the part. The internal magnetic material may be one or more permanent magnets, magnetic wire, magnetic particles or an electromagnet. Suitable materials for permanent magnets include, but are not limited to ferrite magnets, ferrite-rubber magnets, aluminum-nickel-cobalt magnets and rare earth magnets such as samarium-cobalt, or neodymium magnets. The choice of material is based on the desired level of magnetic flux density at the surface of the seal and the conditions that the seal will be subjected to during manufacture and in use. For example, some materials may lose their magnetic properties if exposed to high temperatures, so care must be taken in selecting a magnetic material which will survive both seal manufacturing temperatures and end use environment temperatures.

Magnetic material is generally metallic and, if present at the surface of the elastomer parts of this invention, properties of the parts may be adversely effected. For example, sealing ability, thermal degradation resistance, and surface smoothness may all be harmed by having internal magnetic material at the surface, or too near the surface of the elastomer seal. Additionally, it is best practice not to allow plasma to directly contact the magnetic material. Thus, the manufacturing process for elastomer parts of this invention which contain an internal source of magnetic flux is designed so that the magnetic material is not exposed on the surface of the parts. An example of such a process is: 1) cover the bottom of a mold cavity with a first layer of uncured elastomer; 2) place a second elastomer layer over the first layer, the second layer having at least one appropriately sized and shaped hole for receiving a magnet; 3) inserting a magnet into each hole in the second elastomer layer, aligning the poles of each magnet in the same direction; 4) covering the second elastomer layer with a third elastomer layer; and 5) curing the resulting part under pressure.

Alternatively (Figs. 2A and 2B), the source 112 of the magnetic flux density at the surface of the elastomer part 110 of this invention may be external to the part. In such instances, the magnetic source 112 is placed in close proximity to (but not in contact with) the surface 116 of elastomer part 110 which will be exposed to plasma during use. Typically, the external magnetic source 112 , such as one or more permanent magnets or an electromagnet, is placed along the periphery of the groove 118 in which elastomer part 110 is seated, or along the periphery of the elastomer part where it is bonded to a substrate. External magnetic source 112 should not be directly exposed to plasma during use. In Figs. 2A and 2B, a conductive metal (e.g. aluminum) sheath 114 is employed to shield magnetic source 112 from exposure to plasma.

Alternatively, or in addition to the latter, the external magnetic source may be placed in the substrate to which the seal is pressed against while in use (not shown). Using a slit valve door on a semiconductor manufacturing vacuum chamber as an example, the external magnetic flux source may be placed 1) on the door along the periphery of the seal, 2) around the slit on the chamber in close proximity to where the seal will be in contact when the door is closed, or 3) a combination of both locations may be employed. In each case, the magnetic source is shielded by a metal material so that it is not directly exposed to plasma during use.

The parts of this invention have an internal or external magnetic source, proper alignment of the magnetic field is important in order to maximize the protection from plasma attack afforded to the parts. For the elastomer part to have optimum plasma resistance, the magnetic poles should be aligned such that neither pole is near the surface of the part which will be exposed to plasma.

The elastomer parts used in this invention are particularly suited for use in dry process semiconductor manufacturing processes where they will be subjected to reactive plasma environments. The parts may be used effectively in various applications such as plunger seals, door seals, lip and face seals, gas delivery plate seals, wafer support seals, barrel seals, etc. in such manufacturing processes and equipment.

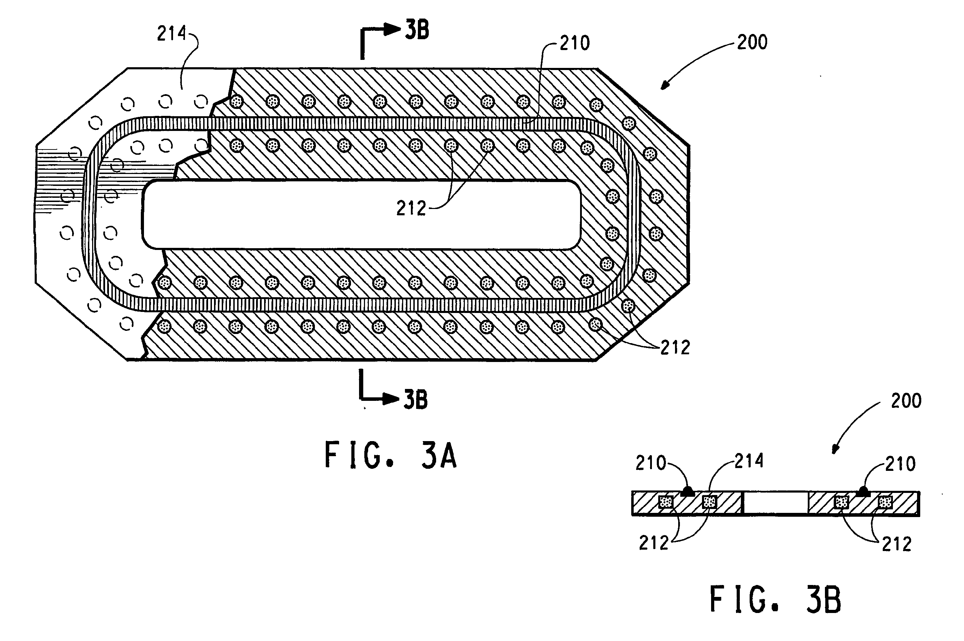

The end use application for the elastomer parts used in this invention is as slit valve door seals (Figs. 3A and 3B) wherein the elastomer part 210 is typically either cured or bonded onto sealing surface 214 of the metal door 200, or seated in a groove on the sealing surface of the door. Bonded door seals are shown in U.S. Patent No. 6,089,543. The door seal may be part of a one- or two-piece door assembly. The slit valve door 200 comprises a seal plate 214 and an elastomer part (i.e. a seal) 210 bonded thereto, said seal 210 having a magnetic flux density of at least 1 mT (10 gauss) (preferably at least 20 mT (200 gauss)) at its surface, i.e. the surface which will be exposed to plasma during use. The source of the magnetic flux is external as described above. An external source, permanent magnets 212 mounted within seal plate 214, in close proximity to seal 210, running along each side of the seal, is depicted in the embodiment shown in Figs. 3A and 3B. Although Figs. 3A and 3B show an embodiment of the invention wherein magnets are located along both sides of seal 210, it is to be understood that an embodiment wherein the magnetic source is located along only one side of seal 210 is also contemplated.

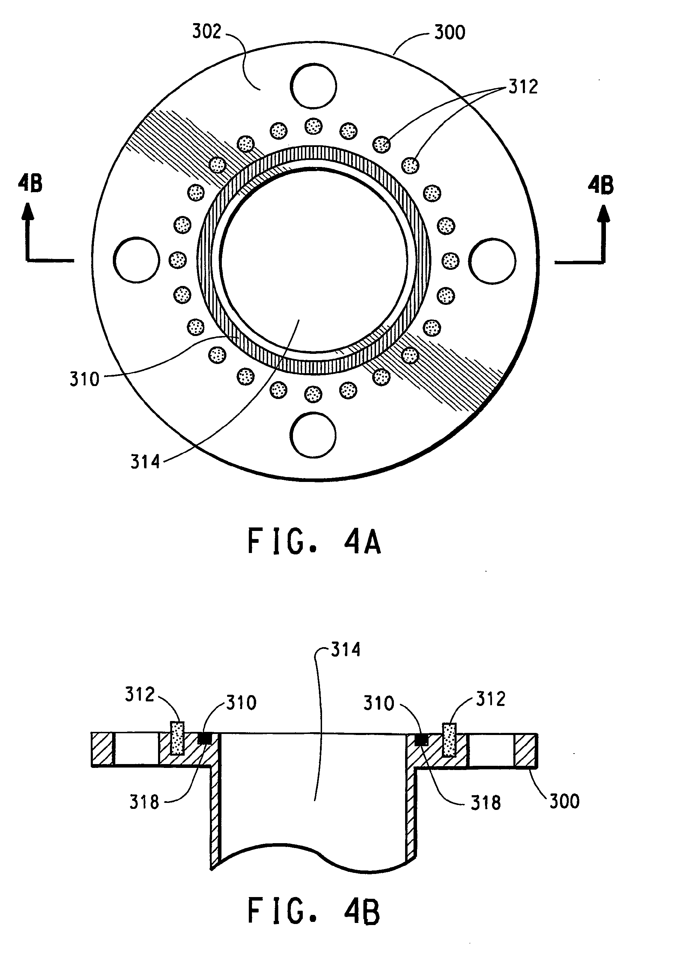

Another useful application of this invention is pipe flanges (Figs. 4A and 4B). In this application, elastomer part 310, having a magnetic flux density at its surface of at least 1 mT (10 gauss) (preferably at least 20 mT (200 gauss)) is mounted in groove 318 on sealing surface 302 of flange 300. Permanent magnets 312 are also mounted on flange 300 around the periphery and in close proximity to seal 310.

### EXAMPLES

The following example is not according to the invention.

### Example

The effect of an external permanent magnet on the plasma resistance of a perfluoroelastomer part was measured in this example. The part employed was an AS-110 Kalrez® perfluoroelastomer O-ring (available from DuPont Dow Elastomers). The O-ring was mounted in a groove formed on the surface of an aluminum block. The groove surrounded a cylindrical (6 mm diameter, 21 mm height) samarium-cobalt magnet (available from Masmaterial Co., Ltd.) that was embedded in the aluminum block (Fig. 2A). The external magnet produced a flux on the surface of the O-ring of 25 mT (250 gauss). A control was also set up wherein no magnet was mounted on the aluminum block.

The mounted O-rings were exposed to a SF₆/Ar (1:2 volume ratio) plasma in a 2.45 GHz microwave cavity plasma reactor (600 watts) at a gas flow rate of 2 sccm, and a pressure of 13 Pa.

After 2 hours exposure, the control O-ring (no external magnet) had lost 2% of its initial weight. The O-ring having a 25 mT (250 gauss) flux density at its surface had lost 0.7% of its initial weight.

The AS-214 O-ring of this invention (containing magnets) and a control AS-214 fluoroelastomer O-ring (not containing any magnets) were exposed to an Ar/O₂ (1:1 volume ratio) plasma in a 2.45 GHz microwave cavity plasma reactor (125 watts) at a gas flow rate of 110 sccm, and a pressure of 3 Pa.

After 60 minutes exposure, the control O-ring (no internal magnet) had lost 2.8% of its initial weight, whereas the O-ring of the invention had lost 1.4% of its initial weight.

## Claims

1. A slit valve door for exposure to reactive plasma, said door having a sealing surface and an elastomer part (210) mounted on said sealing surface and wherein at least one permanent magnet (212) is mounted on said door, said permanent magnet (212) mounted in close proximity to said elastomer part (210) so as to result in a magnetic flux density of at least 1 millitesla (10 gauss) on a surface of said elastomer part (210).

2. A pipe flange for exposure to a reactive plasma, said flange having a sealing surface (302) and an elastomer part (310) mounted on said sealing surface (302) and wherein at least one permanent magnet (312) is mounted on said sealing surface (302), said permanent magnet (312) mounted in close proximity to said elastomer part (310) so as to result in a magnetic flux density of at least 1 millitesla (10 gauss) on a surface (302) of said elastomer part (310).

## Patentansprüche

1. Schlitzventilklappe zur Exponierung an reaktivem Plasma, wobei die Klappe eine dichtende Oberfläche hat sowie ein Elastomer-Teil (210), das auf der dichtenden Oberfläche befestigt ist, wobei mindestens ein Permanentmagnet (212) auf der Klappe befestigt ist und der Permanentmagnet (212) in unmittelbarer Nähe zu dem Elastomer-Teil (210) befestigt ist, so dass eine magnetische Flussdichte von mindestens 1 Millitesla (10 Gauss) auf der Oberfläche des Elastomer-Teils (210) resultiert.

2. Rohrflansch zur Exponierung an einem reaktiven Plasma, wobei der Flansch eine dichtende Oberfläche (302) hat und auf der dichtenden Oberfläche (302) ein Elastomer-Teil (310) befestigt ist und wobei mindestens ein Permanentmagnet (312) auf der dichtenden Oberfläche (302) befestigt ist, wobei der Permanentmagnet (312) in unmittelbarer Nähe zu dem Elastomer-Teil (310) befestigt ist, so dass eine magnetische Flussdichte von mindestens 1 Millitesla (10 Gauss) auf der Oberfläche (302) des Elastomer-Teils (310) resultiert.

## Revendications

1. Porte de valve fendue pour exposition à un plasma réactif, ladite porte présentant une surface d'étanchéité et une pièce en élastomère (210) montée sur ladite surface d'étanchéité, et dans laquelle au moins un aimant permanent (212) est monté sur ladite porte, ledit aimant permanent (212) étant monté à proximité immédiate de ladite pièce en élastomère (210) de manière à obtenir une densité de flux magnétique d'au moins 1 millitesla (10 gauss) sur une surface de ladite pièce en élastomère (210).

2. Bride de tuyau pour exposition à un plasma réactif, ladite bride présentant une surface d'étanchéité (302) et une pièce en élastomère (310) montée sur ladite surface d'étanchéité (302), et dans laquelle au moins un aimant permanent (312) est monté sur ladite surface d'étanchéité (302), ledit aimant permanent (312) étant monté à proximité immédiate de ladite pièce en élastomère (310) de manière à obtenir une densité de flux magnétique d'au moins 1 millitesla (10 gauss) sur une surface (302) de ladite pièce en élastomère (310).
